(19) Europäisches Patentamt

European Patent Office

Office européen des brevets

(11) **EP 2 533 060 B1**

(12) **FASCICULE DE BREVET EUROPEEN**

(45) Date de publication et mention
de la délivrance du brevet:
**30.07.2014 Bulletin 2014/31**

(51) Int Cl.:
*G01R 31/02* *(2006.01)*   *H02H 1/00* *(2006.01)*
*H02H 5/10* *(2006.01)*

(21) Numéro de dépôt: **12354028.8**

(22) Date de dépôt: **27.04.2012**

(54) **Détection directionnelle de défaut à la terre résistant et de rupture de conducteur moyenne tension**

Richtungserkennung eines widerstandsfähigen Erdschlusses und der Unterbrechung eines Leiters mittlerer Spannung

Directional detection of resistive earth fault and medium-voltage conductor breakage

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.06.2011 FR 1101730**

(43) Date de publication de la demande:
**12.12.2012 Bulletin 2012/50**

(73) Titulaire: **Schneider Electric Industries SAS
92500 Rueil-Malmaison (FR)**

(72) Inventeurs:
• **Verneau, Guillaume
  38050 Grenoble Cedex 09 (FR)**
• **Sinistro, Stéphane
  38050 Grenoble Cedex 09 (FR)**
• **Baumes, Nathalie
  38050 Grenoble Cedex 09 (FR)**

(74) Mandataire: **Péru, Laurence et al
Schneider Electric Industries SAS
Service Propriété Industrielle
WTC-38EE1
5 pl. Robert Schuman
38050 Grenoble Cédex 09 (FR)**

(56) Documents cités:
**EP-A1- 1 603 211     US-A1- 2004 141 265**

• BALDWIN T ET AL: "Directional ground fault indicator for high-resistance grounded systems", INDUSTRIAL AND COMMERICAL POWER SYSTEMS TECHNICAL CONFERENCE, 2002. 20 02 IEEE, IEEE, PI, 1 janvier 2002 (2002-01-01), pages 103-109, XP031098490, ISBN: 978-0-7803-7483-6
• DINGDING YUAN ET AL: "Performance Evaluation ofA New Directional Protection Technique for Distribution Lines", POWER SYSTEM TECHNOLOGY, 2006. POWERCON 2006. INTERNATIONAL CONFERENCE ON, IEEE, PI, 1 octobre 2006 (2006-10-01), pages 1-6, XP031053457, ISBN: 978-1-4244-0110-9

**Description**

**DOMAINE TECHNIQUE**

L'invention concerne la détection de défaut sur un réseau électrique de distribution, notamment moyenne tension. En particulier, l'invention propose un principe de détection de défauts résistants entre un conducteur électrique moyenne tension et la terre, défaut par exemple causé par la rupture dudit conducteur, ainsi qu'un dispositif adapté.

**ETAT DE LA TECHNIQUE**

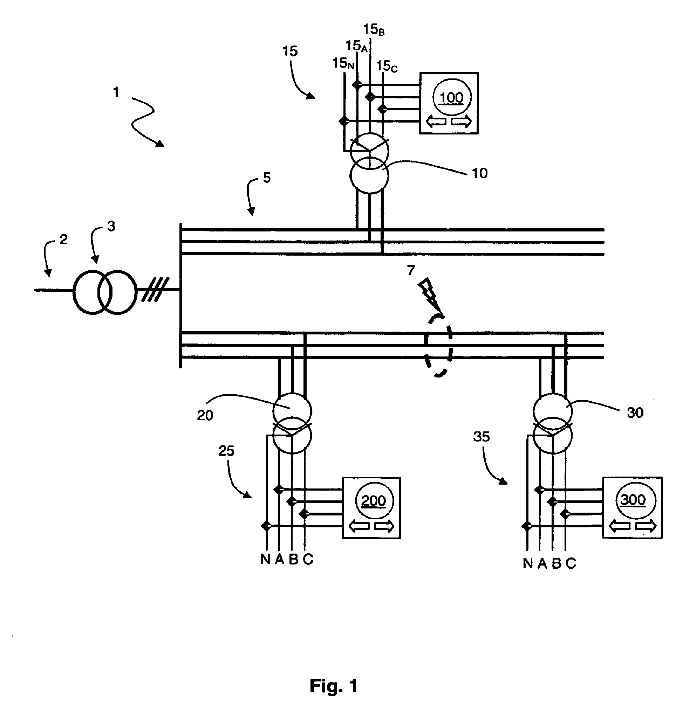

Tel qu'illustré en figure 1, les réseaux 1 de distribution peuvent être décomposés en différents niveaux, avec un premier réseau 2 de transport et de répartition très haute et haute tensions THT/HT (de 35 à plus de 200 kV), utilisé pour transporter ou répartir l'énergie électrique depuis les centrales de production sur de grandes distances. Un réseau de distribution 5 moyenne tension MT, usuellement entre 1 et 35 kV, plus précisément 11 kV tension simple en France, lui succède pour des transports à plus petite échelle, vers des clients de type industriels ou des postes 10, 20, 30 transformant la moyenne tension en basse tension BT (en particulier 0,4 kV en France) ; le réseau basse tension 15, 25, 35 alimente les clients de faible demande énergétique via trois conducteurs de phase $15_A$, $15_B$, $15_C$, et un conducteur de neutre $15_N$.

Le réseau MT 5 peut être composé de lignes aériennes et/ou de câbles souterrains. Quelle que soit la solution, le réseau 5 est sujet à des défauts variés, qu'il est important de détecter et localiser afin de pallier les problèmes générés : rupture d'alimentation, dégradation de la tenue des matériels d'isolation, sans compter la sécurité des personnes. Parmi ces défauts 7, les plus fréquents sont les défauts monophasés, localisés hors du poste source, dans lesquels une phase est en contact avec la terre, ou la rupture d'un câble aérien en cas d'intempérie notamment.

Ces défauts 7, tout comme les défauts polyphasés qui concernent plusieurs phases, sont de type court-circuit et à l'origine de courants élevés, pouvant atteindre plusieurs milliers ou dizaines de milliers d'ampères, alors que les conducteurs et/ou équipements sont généralement conçus pour supporter quelques centaines d'ampères en fonctionnement nominal. Par exemple, lorsque le neutre N du transformateur est directement mis à la terre, le courant de défaut correspond à la tension du réseau 5, divisée par la somme des résistances du circuit, très faible.

Une option pour détecter ce type de défaut est de mesurer le courant circulant, ou des paramètres qui lui sont relatifs. Ces mesures doivent cependant être complétées par des mesures sur les tensions triphasées, si on veut donner la direction relative (amont ou aval) par rapport à l'équipement de détection des défauts. Or, la tension MT du réseau 5 génère une complication dans l'accès aux points de mesure, et des problématiques d'isolement du matériel électronique : ce type de détection directionnelle est difficile à mettre en oeuvre.

Par ailleurs, la détection du courant de court-circuit elle-même peut devenir complexe. En particulier, la mise à la terre du réseau MT est désormais généralement réalisée par une impédance : un élément limitatif de type résistance ou bobine de compensation est inséré entre le secondaire du point neutre N du transformateur 3 et la terre afin d'augmenter l'impédance globale du chemin de circulation du courant de défaut, et donc diminuer ledit courant. Ceci permet d'alléger le stress sur les composants du réseau 5, et également de protéger les personnes. Des mesures plus fines du courant (« *sensitive earth fault* ») doivent alors être réalisées.

D'autres éléments sont par ailleurs susceptibles de limiter la valeur du courant de défaut et compliquer la détection : la résistance du sol entre en jeu, tout comme la nature du défaut 7. Or, si les paramètres du sol peuvent être pris en compte en adaptant, au moment de l'installation, les réglages des équipements de protection et de détection, il n'en est pas de même des caractéristiques du défaut, non prévisibles. Parmi les défauts les plus difficilement détectables, on trouve notamment la rupture de conducteur MT, qui pourra se faire avec ou sans contact à la terre.

Pour ces défauts très résistants, une détection via la tension est donc mise en oeuvre. Par exemple, le document EP 1 603 211 concerne un équipement communicant installé aux extrémités des lignes : la détection de rupture de conducteur est réalisée par simple détection de perte de tension de ligne. Des études plus théoriques indiquent la possibilité d'utiliser la tension inverse et/ou la tension homopolaire sur le réseau MT 5 ; cependant, les problèmes inhérents à la mesure de la tension sur des conducteurs de phase moyenne tension précédemment mentionnée restent entiers.

Il apparaît ainsi que la détection et la localisation de défauts résistifs sur un réseau moyenne tension, notamment dans le cas de ruptures de conducteurs, est peu développée en raison de l'utilisation de mesures complexes à mettre en oeuvre, en particulier les prises de tension sur les conducteurs moyenne tension et des mesures précises des courants de court-circuit y circulant.

**EXPOSE DE L'INVENTION**

Parmi autres avantages, l'invention vise à pallier des inconvénients des systèmes de détection existants et à proposer une détection, de préférence directionnelle, de défauts de terre résistants en moyenne tension, avec un focus spécifique sur les ruptures de conducteurs. En particulier, l'invention propose l'utilisation de mesures sur le réseau basse tension, en aval du poste MT/BT, pour détecter et identifier un défaut du côté moyenne tension. L'invention est notamment définie dans les revendications jointes.

Sous un aspect, l'invention concerne un procédé de détection de défaut terre résistif, en particulier de défaut dû à la rupture d'un conducteur, sur un réseau moyenne tension qui alimente une pluralité de départs basse tension. Le procédé comprend la détermination, pour chaque départ, de la tension inverse correspondant à la composante symétrique des tensions de phase, la comparaison de l'amplitude de ces tensions inverses avec un seuil, avantageusement réglable, et l'indication de l'occurrence d'un défaut lorsque le seuil est dépassé au moins une fois.

Sous un autre aspect, le procédé de détection est associé à une localisation relative du défaut détecté. A cette fin, les tensions de phase sont traitées et le résultat du traitement permet de déterminer si le défaut détecté est en amont ou en aval du point de mesure. En particulier, la norme ou l'amplitude des tensions de phase de chaque départ est déterminée, ainsi que leur valeur moyenne et leur valeur minimale pour chaque départ ; la valeur moyenne est comparée aux amplitudes, et la valeur minimale est comparée à un seuil.

Sous un autre aspect, l'invention concerne un dispositif adapté au procédé de détection, et de préférence au procédé de détection directionnelle précédents, adapté pour un réseau moyenne tension qui comprend au moins un poste de transformation moyenne tension / basse tension défmissant un départ vers une pluralité de conducteurs de phase basse tension.

Le dispositif précédent est selon un autre aspect de l'invention associé en un système afin de permettre de surveiller le réseau moyenne tension. A cette fin, le dispositif reçoit des signaux représentatifs des tensions de chaque conducteur pour chaque départ et est apte à les traiter, ou une pluralité de dispositifs est mise en oeuvre au niveau de chaque départ, ou toute autre combinaison avec par exemple un dispositif apte à recevoir les informations relatives à une branche du réseau. Le système comprend en outre des moyens pour indiquer l'occurrence du défaut, et de préférence sa localisation relative, amont ou aval, par rapport aux points d'obtention des signaux reçus par le système.

Notamment, le dispositif de détection d'un défaut terre résistant comprend des moyens pour recevoir des signaux représentatifs des tensions de chaque conducteur d'un départ basse tension, des moyens d'obtention des signaux représentatifs des tensions de phase à partir des signaux de tension reçus, des moyens pour déterminer la composante symétrique de tension inverse du départ, des moyens pour comparer la tension inverse à un seuil de déclenchement, et avantageusement des moyens de réglage du seuil de déclenchement. De préférence, le dispositif de détection est mis en place sur chacun des départs basse tension alimentés, notamment localisé dans le poste de transformation, et le système ainsi formé comprend des moyens pour indiquer l'occurrence d'un défaut dans le réseau moyenne tension lorsque les moyens de comparaison d'un des dispositifs de détection donnent un résultat dans lequel le module de la tension inverse dépasse le seuil de déclenchement. Alternativement, le système de détection d'un défaut résistant dans un réseau moyenne tension selon l'invention comprend au moins un dispositif de détection dont les moyens sont aptes à recevoir des signaux représentatifs des tensions de chaque conducteur de chaque départ basse tension, à obtenir des signaux représentatifs des tensions de phase pour chaque départ, à en déterminer la composante symétrique de tension inverse, et à comparer le module de chaque tension inverse au seuil de déclenchement, ainsi que des moyens pour indiquer l'occurrence d'un défaut dans le réseau moyenne tension lorsque les moyens de comparaison donnent un résultat dans lequel une tension inverse dépasse le seuil de déclenchement.

Dans le cas où le neutre des postes de transformation moyenne tension / basse tension est relié à la terre, le système selon l'invention comprend en outre des capteurs de tension sur chaque conducteur de phase et sur le conducteur de neutre.

Le dispositif selon l'invention est avantageusement adapté pour la détection directionnelle du défaut résistant, en comprenant en outre des moyens de traitement des signaux représentatifs des tensions de phase, et des moyens d'interprétation des résultats du traitement des signaux pour déterminer si le défaut est en amont ou en aval du point de mesure des signaux reçus par ledit dispositif. En particulier, les moyens de traitement comprennent des moyens de calcul de la norme des tensions de phase, des moyens de calcul de la moyenne des normes, des moyens de détermination du minimum des normes, des premiers moyens de comparaison de la norme des tensions de phase avec leur moyenne, et des deuxièmes moyens de comparaison du minimum des normes avec un seuil.

## BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.

La figure 1 illustre un réseau sur lequel la détection selon l'invention est utilisée.

Les figures 2A et 2B montrent des conséquences de différents défauts sur les tensions des lignes BT.

La figure 3 schématise les étapes d'un procédé selon un mode de réalisation de l'invention.

La figure 4 représente un dispositif de détection directionnelle selon un mode de réalisation préféré de l'invention.

**DESCRIPTION DETAILLEE D'UN MODE DE REALISATION PREFERE**

Lors de l'apparition d'un défaut terre résistant 7 dans le réseau MT 5, la tension qui y circule est perturbée au moins dans la phase concernée, et ces perturbations peuvent être identifiées au niveau des réseaux BT 15, 25, 35 distribués par le réseau MT 5. Dans le réseau multiphasé 1 précédemment décrit en figure 1, la détection d'un défaut selon l'invention est mise en oeuvre par l'intermédiaire de dispositifs de détection directionnelle 100, 200, 300 au niveau de chaque départ BT.

Dans le mode de réalisation et d'utilisation préféré illustré de l'invention, le dispositif 100 est associé à chaque transformateur 10, qui comprend trois conducteurs de phase $15_A$, $15_B$, $15_C$ et un conducteur de neutre $15_N$. Cependant, il est possible de s'écarter de cette situation idéale, et le réseau peut comprendre un autre nombre de phases, et notamment le neutre peut être compensé.

En cas de défaut résistif 7 sur le réseau MT 5, trois options se présentent : des dispositifs de détection directionnelle 100 sont associés à des départs sains 15, des dispositifs 200 sont situés en amont du défaut 7, et des dispositifs 300 sont localisés en aval du défaut 7. Le défaut 7 crée une perturbation évidente sur la tension V des phases qu'il affecte en aval dudit défaut ; cependant, dans certains cas, d'autres phases peuvent être altérées, tout comme également les réseaux BT amont, voire même les départs sains 15.

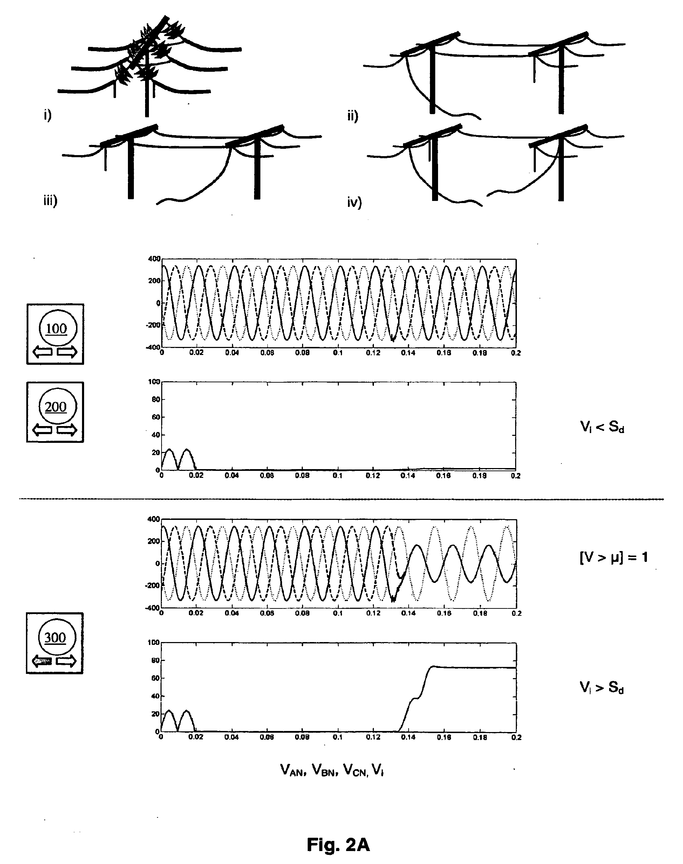

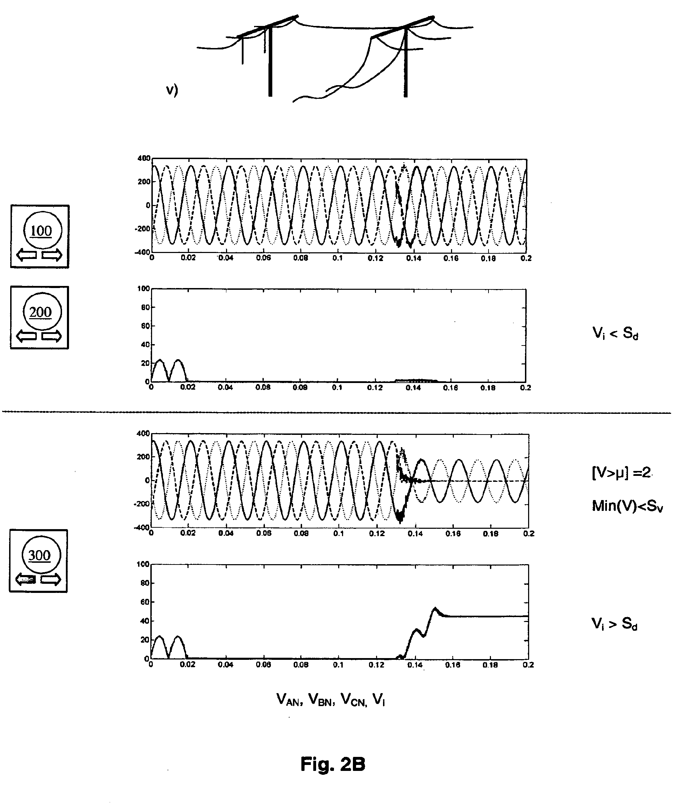

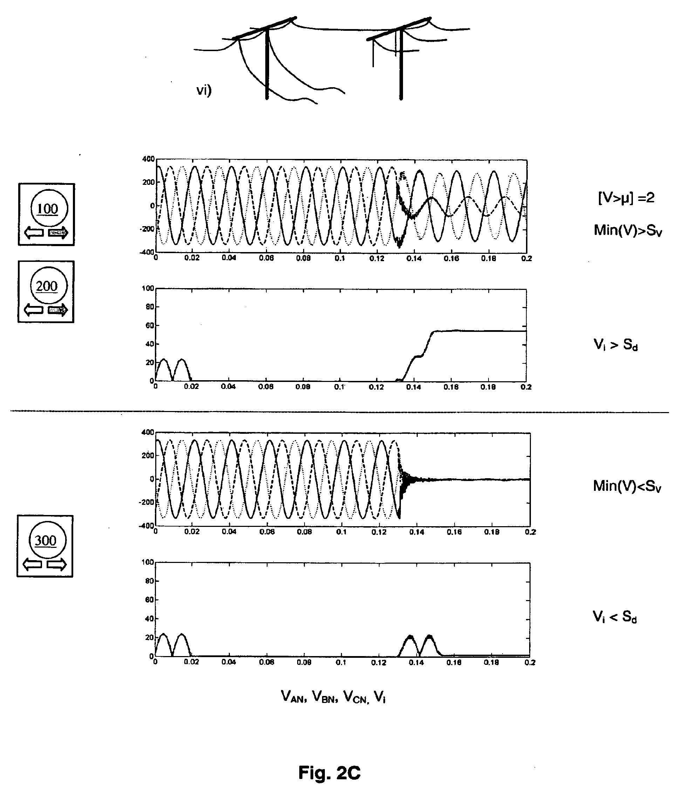

Notamment, en figures 2 sont illustrés des défauts dans le cas de réseaux aériens triphasés; la même représentation graphique a été reprise, avec le côté amont du défaut situé à gauche sur le schéma. Six types de défauts peuvent être identifiés (on écarte la situation de trois conducteurs rompus, car aucune information d'ordre électrique n'est alors disponible, et on ne considère que les défauts simultanés) :

i) rupture au niveau d'un « jumper », élément qui permet de passer les isolants de part et d'autre du poteau qui supporte les lignes (c'est-à-dire que le défaut 7 est de résistance infinie, avec aucun conducteur à la terre) ;
ii) rupture d'un seul conducteur avec mise à la terre côté amont ;
iii) rupture d'un seul conducteur avec mise à la terre côté aval ;
iv) rupture de deux conducteurs, un étant mis à la terre côté amont et l'autre côté aval ;
v) rupture de deux conducteurs avec mise à la terre côté aval ;
vi) rupture de deux conducteurs avec mise à la terre côté amont.

De fait, dans les autres cas, par exemple un conducteur à terre et un jumper rompu, un des deux phénomènes précède l'autre, et aura auparavant été détecté.

Dans les quatre premiers cas i), ii), iii) et iv), tel qu'illustré en figure 2A, seule la tension V en aval du défaut 7 est affectée ; une des phases reste invariante, et les deux autres tensions de phase voient leur amplitude diminuer. Dans le cas v) de la rupture de deux conducteurs avec mise à la terre côté aval également (figure 2B), seule la tension en aval est affectée, avec diminution de la tension de chaque phase, l'une d'elles s'annulant même. Par contre, dans le cas vi) de la rupture de deux conducteurs avec mise à la terre côté amont, il y a modifications de la tension également en amont 25, et même sur le départ sain 15, avec annulation complète en aval 35.

Pour chacun des points de mesure, il est possible de calculer, via une matrice de Fortescue, les composantes symétriques de la tension ($V_d$ tension directe, $V_i$ tension inverse et $V_o$ tension homopolaire pour les tensions de phase $V_{AN}$, $V_{BN}$, $V_{CN}$) :

$$\begin{bmatrix} V_d \\ V_i \\ V_o \end{bmatrix} = \frac{1}{3} \cdot \begin{bmatrix} 1 & a & a^2 \\ 1 & a^2 & a \\ 1 & 1 & 1 \end{bmatrix} \cdot \begin{bmatrix} V_{AN} \\ V_{BN} \\ V_{CN} \end{bmatrix}, \text{ avec } a = e^{j\frac{2\pi}{3}},$$

Dans tous les cas de défaut précités, on note que le module de la tension inverse $V_i$ dépasse un seuil $S_d$ que l'on peut fixer entre 4 et 20 % du courant nominal, de préférence 12 %, en au moins un des points de mesure 100, 200, 300. Il est ainsi possible de détecter la présence d'un défaut par le calcul de cette composante symétrique. En cas d'un réseau à n phases, les formules précédentes, notamment celle de la matrice de Fortescue, sont à adapter en remplaçant le chiffre 3 par n.

Le défaut détecté est en aval du point de mesure, à l'exception d'une situation vi) où seuls les départs amont 25 et sain 15 indiquent sa présence. Pour localiser relativement le défaut 7 par rapport au point de mesure 100, 200, 300, il importe ainsi d'identifier le dernier cas vi) dans lequel $V_{i300} < S_d$. On constate que, pour les quatre premiers cas i), ii), iii), iv) seulement et pas dans le cas problématique vi), pour le point de mesure en aval du défaut, la moyenne $\mu$ entre les amplitudes des tensions de phase est supérieure à deux valeurs nominales $\|V_{XN}\|$. Par ailleurs, pour discriminer les deux cas restants v) et vi), dans lesquels la moyenne entre les amplitudes des tensions de phases est inférieure à deux valeurs nominales que l'on soit en amont ou en aval du défaut 7, on constate que le point de mesure aval au défaut indique qu'au moins une des tensions de phases s'est annulée, c'est-à-dire que le minimum $V_{min}$ des amplitudes de tensions de phase $\|V_{XN}\|$ est inférieur à un seuil $S_v$. Il est donc possible, uniquement en connaissant les tensions de phases, de déterminer si le défaut détecté est en amont ou en aval de la mesure.

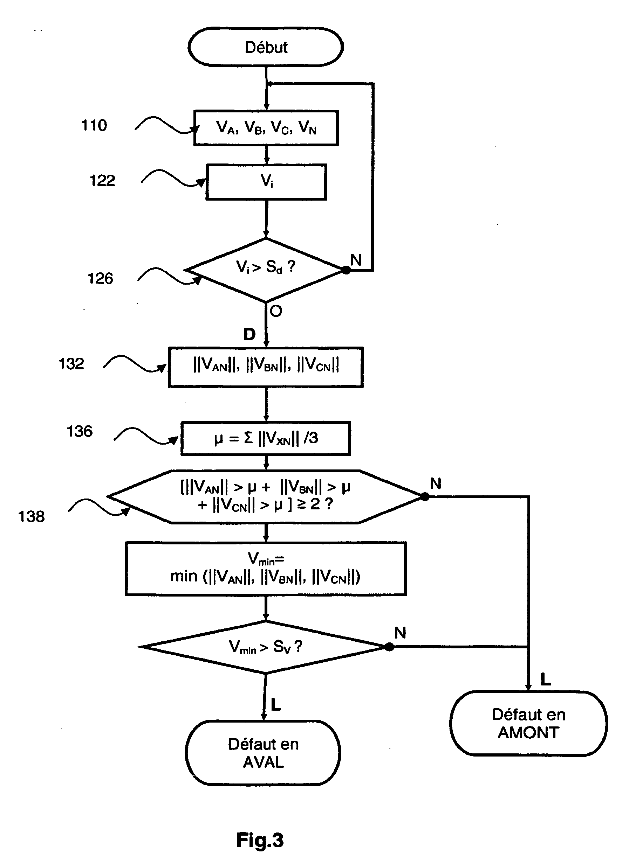

Le principe de détection et localisation selon l'invention repose ainsi sur la mesure dans les réseaux BT 15, 25, 35 distribués des tensions de phase uniquement pour détecter, via la tension inverse, puis localiser relativement, via les amplitudes, un défaut résistif de type rupture de conducteur. Dans un premier stade, tel qu'illustré en figure 3, la tension $V_A$, $V_B$, $V_C$ de chaque phase est mesurée sur le réseau BT 15, 25, 35, ainsi que la tension du neutre $V_N$; la composante symétrique inverse $V_i$ est déterminée, par la formule adaptée. Si la tension inverse $V_i$ ne dépasse pas un seuil de déclenchement $S_d$, aucun défaut n'est détecté dans le réseau alimentant directement le départ, et les mesures reprennent à intervalle défini, pour une surveillance continue.

Lorsque la tension inverse $V_i$ dépasse le seuil de déclenchement $S_d$, un défaut résistif est identifié et le deuxième stade du procédé, c'est-à-dire la localisation directionnelle, peut être mis en oeuvre. La détection simple de l'occurrence d'un défaut peut être notifiée à l'utilisateur par l'allumage d'une diode, ou autre système d'alerte.

Pour localiser le défaut 7 en amont ou en aval du point de mesure des tensions $V_{XN}$, les amplitudes $\|V_{XN}\|$ des tensions, par exemple la valeur efficace RMS (« *Root Mean Square* » selon la terminologie anglo-saxonne) ou autre, sont déterminées pour chaque phase X et leur moyenne arithmétique $\mu$ calculée. Si au moins deux valeurs de normes $\|V_{XN}\|$ dépassent la moyenne $\mu$, alors le défaut 7 est en amont du point de mesure 300. Sinon, on calcule la valeur minimale $V_{min}$ des amplitudes de tensions de phase $\|V_{XN}\|$, et si cette valeur minimale $V_{min}$ dépasse un seuil $S_v$ fixé par exemple à 5 % de la valeur nominale du réseau, le défaut 7 est en amont du point de mesure 300, sinon, il est en aval.

Certes, la localisation du défaut 7 en aval du point de mesure concerne autant un départ sain 15 qu'un transformateur 20 situé dans la ligne en défaut. Il est cependant facile alors d'identifier la branche du réseau MT 5 en défaut, étant donné que c'est le seul départ pour lequel au moins un détecteur 300 installé ne signale pas de défaut. De fait, un défaut est localisé L entre deux points de mesure, l'un répondant à tous les critères précédents et l'autre non.

Le résultat D, L peut être indiqué soit directement au niveau des postes de transformation, par allumage de diodes, notamment de couleur différente, soit via un système centralisé de type report sur un schéma fonctionnel du réseau 1, par exemple par télésignalisation vers un centre de contrôle.

En conclusion, grâce à ce principe de signalisation, il est possible de localiser le défaut 7, qui, dans tous les cas et quelle que soit la situation, se situe entre un détecteur « allumé » et un détecteur « éteint » : la détection de défaut terre résistant, de rupture de conducteur MT, est réalisée sans capteur de courant (donc sans limite basse de détection), par des mesures de tension installée en BT, qui, outre la facilité d'installation, offrent une meilleure précision de mesure.

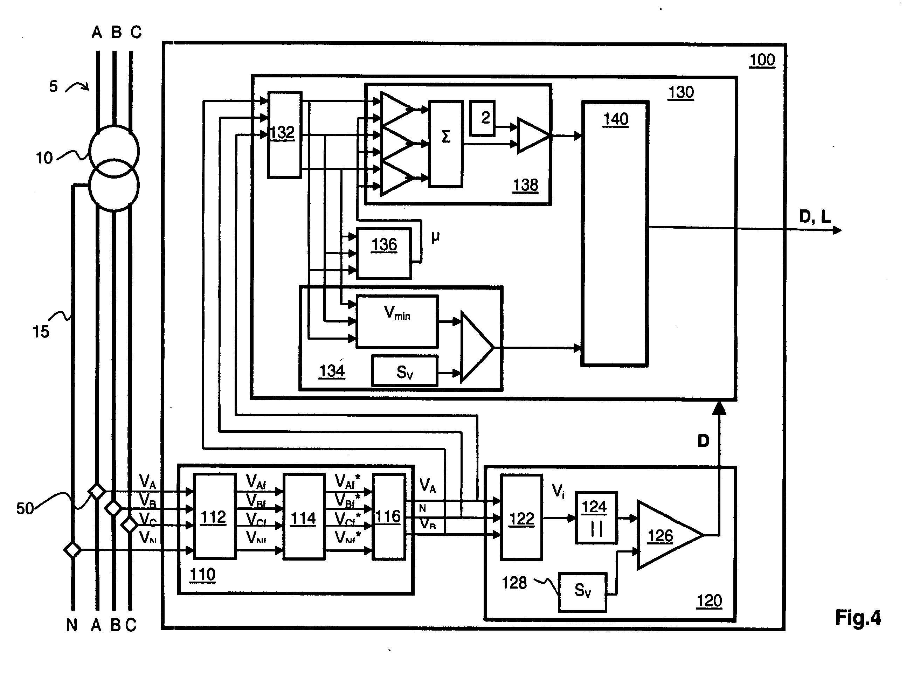

Des moyens de détection 50 de type capteur de tension sont donc mis en place sur chaque départ BT, en particulier au niveau BT des transformateurs 10, 20, 30 alimentés par le réseau MT 5. Ils sont associés à un système de surveillance du réseau MT, comprenant des dispositifs de détection directionnelle 100, 200, 300 permettant de traiter les informations de chaque départ, lesdits dispositifs 100, 200, 300 pouvant être intégrés à chaque transformateur 10, 20, 30 ou faire partie d'un système central auquel les informations de chaque capteur 50 sont transmises. Les données de ces dispositifs de détection directionnelle 100, 200, 300 permettront d'identifier la localisation relative du défaut, entre deux dispositifs. Un mode de réalisation préféré d'un dispositif adapté pour mettre en oeuvre le procédé selon l'invention est illustré en figure 4.

Le dispositif de détection directionnelle selon l'invention 100 comprend des moyens 110 permettant d'obtenir des signaux représentatifs des tensions de phase $V_A$, $V_B$, $V_C$, $V_N$ fournis par les capteurs 50 et reçus par des moyens adaptés du dispositif 100. Dans le mode de réalisation préféré, les signaux, avantageusement filtrés par des moyens 112 adaptés comme un filtre analogique, $V_{Af}$, $V_{Bf}$, $V_{Cf}$, $V_{Nf}$ sont en outre conditionnés et les moyens d'obtention des signaux représentatifs 110 comprennent un module d'échantillonnage 114, fonctionnant notamment à plus de 1 kHz, fournissant ainsi des signaux échantillonnés filtrés $V_{Af}^*$, $V_{Bf}^*$, $V_{Cf}^*$ à des moyens de calcul des phaseurs complexes 116 permettant d'obtenir les tensions de phase $V_{AN}$, $V_{BN}$, $V_{CN}$. Il est à noter que si le neutre du réseau BT n'est pas distribué, l'utilisation des mesures des tensions entre phases $U_{AB}$, $U_{BC}$, $U_{CA}$ permet de reconstituer un neutre artificiel par transformation triangle étoile.

Les signaux $V_{XN}$ issus des moyens d'obtention 110 sont transmis à un bloc de détection 120 d'un défaut 7, qui comprend en particulier des moyens 122 de détermination d'au moins une $V_i$ des composantes symétriques de la tension, notamment par l'intermédiaire d'une matrice de Fortescue. Le module de la tension inverse $|V_i|$ est déterminé par les moyens adéquats 124. Le bloc de détection 120 comprend des moyens 126 de comparaison du module de la tension inverse $|V_i|$ avec un seuil de détection $S_d$ : si le seuil est dépassé, alors un défaut D est détecté et un bloc de traitement 130 est activé. Avantageusement, des moyens 128 sont prévus pour régler le seuil $S_d$ de déclenchement, notamment entre 4 et 20 % de la valeur nominale en France.

Le bloc de traitement 130 reçoit les signaux $V_{AN}$, $V_{BN}$, $V_{CN}$ des moyens d'obtention 110. Il comprend des moyens de calcul 132 de leur norme (ou amplitude, valeur efficace ou autre) $\|V_{AN}\|$, $\|V_{BN}\|$, $\|V_{CN}\|$ ; 1a valeur obtenue est transmise à des premiers moyens de comparaison 134 du minimum de la norme $V_{min}$ avec un seuil $S_v$. Parallèlement, les normes obtenues $\|V_{AN}\|$, $\|V_{BN}\|$, $\|V_{CN}\|$ sont transmises successivement à des moyens de calcul 136 de la moyenne arithmétique $\mu$ des trois données entrées, et à des seconds moyens de comparaison 138, qui comprennent une quatrième entrée correspondant à la moyenne calculée $\mu$. Les moyens de comparaison 132, 138 sont reliés à des moyens d'interprétation 140 dont la sortie est un signal L de détection directionnelle de défaut terre en aval ou en amont des capteurs 50 selon le résultat de l'interprétation.

Les deuxièmes moyens de comparaison 138 comparent chacune des valeurs de norme $\|V_{XN}\|$ avec leur moyenne $\mu$ et donnent avantageusement un signal binaire selon le sens de la comparaison aux moyens d'interprétation 140 ; dans un mode de réalisation préféré, les moyens d'interprétation 140 ou les deuxièmes moyens de comparaison 138 comprennent des moyens de sommation des résultats binaires de la comparaison.

Les éléments 110, 120, 130 du dispositif de détection directionnelle peuvent être regroupés au sein d'un appareil, qui peut par exemple être couplé à quatre capteurs 50 et localisés dans un poste de transformation MT/BT ; ils peuvent également être séparés, avec par exemple les moyens d'obtention 110 associés aux capteurs 50 au sein d'un poste de transformation, et les blocs de détection et de traitement intégrés à une centrale de contrôle, les tensions de phase étant transmises à ces blocs de façon automatique ou non. En particulier, il est possible que chacun des blocs 110, 120, 130 soit apte à traiter une pluralité de départ, simultanément ou en séquence, et comprenne des mémoires de stockage adaptées.

Ainsi, selon l'invention, des moyens de mesure de la tension de chaque conducteur sont mis en place sur les départs BT, de préférence au niveau de chaque transformateur alimenté par le réseau MT à surveiller. Les moyens de mesure sont adaptés pour mesurer la tension de chaque phase et la tension du neutre ; les signaux obtenus sont transmis à un ou plusieurs dispositifs de détection qui sont aptes à déterminer la tension inverse résultante ainsi que l'amplitude. La solution selon l'invention présente l'avantage de considérer la problématique de la rupture de conducteurs MT en se plaçant du point de vue des tensions dans le réseau BT dans lequel l'instrumentation de mesure est plus simple, et en considérant de manière exhaustive l'ensemble des situations possibles pour un ou deux conducteurs rompus (pour un réseau triphasé).

Le système ou le procédé selon l'invention peuvent être associés à des appareils de protection du réseau 5, par exemple un relai de protection qui déclenche et isole la branche du réseau en défaut en cas de détection d'un défaut dans ladite branche. Selon une autre option, une signalisation différée seule peut être envisagée, par exemple par l'intermédiaire d'un journal d'événements. De fait, tout type de signalisation directe, locale ou à distance, immédiate ou différée, ou tout type d'action plus radicale peut être associée à la détection selon l'invention.

Bien que l'invention ait été décrite en référence à un réseau aérien, elle ne s'y limite pas : l'invention trouve la même application et les mêmes modes de réalisation pour un réseau partiellement ou en totalité souterrain, dans lequel les ruptures de câbles peuvent survenir suite à des détériorations d'isolants ou des ruptures d'autres éléments peuvent être concernés par l'invention. De plus, les éléments présentés pour réaliser les fonctions précédentes peuvent être remplacés par des équivalents : notamment, la tension peut être mesurée par tout type de capteur (résistif, capacitif, champ électrique,...), et les moyens de traitement des signaux peuvent prendre les formes adaptées, notamment pour le calcul de la tension inverse.

**Revendications**

**1.** Dispositif (100) de détection d'un défaut terre résistant (7) dans un réseau moyenne tension (5) qui comprend au moins un poste de transformation moyenne tension / basse tension (10) définissant un départ (15) vers une pluralité de conducteurs de phase basse tension ($15_A$, $15_B$, $15_C$), ledit dispositif (100) comportant :

    - des moyens pour recevoir des signaux représentatifs des tensions de chaque conducteur d'un départ basse tension (15) ;
    - des moyens d'obtention (110) des signaux représentatifs des tensions de phase ($V_{AN}$, $V_{BN}$, $V_{CN}$) à partir des signaux de tension reçus ;
    - des moyens (122) pour déterminer la composante symétrique de tension inverse ($V_i$) du départ ;
    - des moyens (126) pour comparer la tension inverse ($V_i$) à un seuil de déclenchement ($S_d$).

**2.** Dispositif de détection selon la revendication 1 comprenant en outre des moyens (128) de réglage du seuil de déclenchement ($S_d$).

**3.** Système de détection d'un défaut résistant (7) dans un réseau moyenne tension (5) qui comprend une pluralité de postes de transformation moyenne tension / basse tension (10, 20, 30) définissant chacun un départ (15, 25, 35) vers une pluralité de conducteurs de phase basse tension ($15_A$, $15_B$, $15_C$), ledit système comportant :

   - au moins un dispositif de détection (100) selon l'une des revendications précédentes, les moyens (110, 122, 126) dudit dispositif de détection (100) étant aptes à recevoir des signaux représentatifs des tensions de chaque conducteur de chaque départ basse tension (15, 25, 35), à obtenir des signaux représentatifs des tensions de phase pour chaque départ (15, 25, 35), à en déterminer la composante symétrique de tension inverse ($V_i$), et à comparer le module de chaque tension inverse ($V_i$) au seuil de déclenchement ($S_d$), et
   - des moyens pour indiquer (D) l'occurrence d'un défaut (7) dans le réseau moyenne tension (5) lorsque les moyens de comparaison (126) donnent un résultat dans lequel une tension inverse ($V_i$) dépasse le seuil de déclenchement ($S_d$).

**4.** Système de détection d'un défaut résistant (7) dans un réseau moyenne tension (5) qui comprend une pluralité de postes de transformation moyenne tension / basse tension (10, 20, 30) définissant chacun un départ (15, 25, 35) vers une pluralité de conducteurs de phase basse tension, ledit système comportant un dispositif de détection (100, 200, 300) selon l'une des revendications 1 ou 2 associé à chaque départ (15, 25, 35) et des moyens pour indiquer (D) l'occurrence d'un défaut (7) dans le réseau moyenne tension (5) lorsque les moyens de comparaison (126) d'un des dispositifs de détection (300) donnent un résultat dans lequel le module de la tension inverse ($V_i$) dépasse le seuil de déclenchement ($S_d$).

**5.** Système de détection selon la revendication 4 dans lequel chaque dispositif de détection (100, 200, 300) est localisé dans le poste de transformation (10, 20, 30).

**6.** Système de détection selon l'une des revendications 3 à 5 dans lequel le neutre des postes de transformation moyenne tension / basse tension (10, 20, 30) est relié à la terre, et comprenant en outre des capteurs de tension sur chaque conducteur de phase et sur le conducteur de neutre.

**7.** Dispositif (100) de détection directionnelle d'un défaut résistant (7) dans un réseau moyenne tension (5) qui comprend au moins un poste de transformation moyenne tension / basse tension (10) définissant un départ (15) vers une pluralité de conducteurs de phase basse tension ($15_A$, $15_B$, $15_C$), ledit dispositif comprenant un dispositif de détection selon l'une des revendications 1 à 2, des moyens de traitement (130) des signaux représentatifs des tensions de phase ($V_{AN}$, $V_{BN}$, $V_{CN}$), et des moyens (140) d'interprétation des résultats du traitement des signaux pour déterminer si le défaut est en amont ou en aval du point de mesure des signaux reçus par ledit dispositif (100).

**8.** Dispositif de détection directionnelle selon la revendication 7 dans lequel les moyens de traitement (130) comprennent :

   - des moyens de calcul (132) de la norme des tensions de phase ($\|V_{AN}\|$, $\|V_{BN}\|$, $\|V_{CN}\|$) ;
   - des moyens (136) de calcul de la moyenne ($\mu$) des normes ($\|V_{AN}\|$, $\|V_{BN}\|$, $\|V_{CN}\|$) ;
   - des moyens de détermination du minimum des normes ($V_{min}$) ;
   - des premiers moyens (138) de comparaison de la norme des tensions de phase avec leur moyenne ($\mu$) ;
   - des deuxièmes moyens de comparaison (134) du minimum des normes avec un seuil ($S_v$).

**9.** Système de détection et localisation d'un défaut résistant (7) dans un réseau moyenne tension (5) qui comprend une pluralité de postes de transformation moyenne tension / basse tension (10, 20, 30) définissant chacun un départ (15, 25, 35) vers une pluralité de conducteurs de phase basse tension, ledit système comprenant un système de détection selon l'une des revendications 3 à 6 dans lequel les dispositifs de détection (100, 200, 300) sont des dispositifs de détection directionnelle selon l'une des revendications 7 ou 8, et dans lequel les moyens pour indiquer (D) l'occurrence d'un défaut (7) dans le réseau moyenne tension (5) sont adaptés pour indiquer si le défaut est en amont ou en aval du point de mesure des signaux reçus par lesdits dispositifs de détection.

**10.** Procédé de détection d'un défaut terre résistant (7) sur un réseau moyenne tension (5) comprenant l'obtention des tensions de chaque phase des départs basse tension (15, 25, 35) alimentés par le réseau moyenne tension (5), la détermination de la tension inverse ($V_i$) des départs basse tension, la comparaison des modules des tensions inverses ($V_i$) avec un seuil ($S_d$), l'indication de l'occurrence d'un défaut (7) lorsqu'une comparaison au moins indique que le seuil ($S_d$) est dépassé.

**11.** Procédé de détection selon la revendication 10 comprenant en outre le réglage du seuil ($S_d$).

**12.** Procédé de détection et localisation d'un défaut terre résistant (7) sur un réseau moyenne tension (5) comprenant le procédé de détection selon l'une des revendications 10 ou 11, la détermination de la norme des tensions de phase ($\|V_{AN}\|$, $\|V_{BH}\|$, $\|V_{CN}\|$), le traitement des normes des tensions de phase ($\|V_{AN}\|$, $\|V_{BN}\|$, $\|V_{CN}\|$), la détermination de la localisation du défaut détecté en amont ou en aval du point de mesure.

**13.** Procédé de détection et localisation selon la revendication 12 dans lequel le traitement des normes comprend comprenant le calcul de leur moyenne arithmétique, la comparaison de l'amplitude des tensions avec leur moyenne, la comparaison du minimum de tension avec un seuil.


**Patentansprüche**

**1.** Vorrichtung (100) zum Detektieren eines Erdschlusswiderstandsfehlers (7) in einem Mittelspannungsnetz (5), das wenigstens eine Mittelspannungs-/Niederspannungs-Transformatorstation (10) umfasst, die einen Ausgangspunkt (15) zu mehreren Niederspannungs-Phasenleitern ($15_A$, $15_B$, $15_C$) definiert, wobei die Vorrichtung (100) Folgendes umfasst:

- Mittel zum Empfangen von Signalen, die die Spannungen jedes Leiters eines Niederspannungsausgangspunkts (15) repräsentieren;
- Mittel (110) zum Erhalten von Signalen, die Phasenspannungen ($V_{AN}$, $V_{BN}$, $V_{CN}$) repräsentieren, anhand der empfangenen Spannungssignale;
- Mittel (122) zum Bestimmen der symmetrischen Komponente der inversen Spannung ($V_i$) des Ausgangspunkts;
- Mittel (126) zum Vergleichen der inversen Spannung ($V_i$) mit einem Auslöseschwellenwert ($S_d$).

**2.** Detektionsvorrichtung nach Anspruch 1, die außerdem Mittel (128) zum Regulieren des Auslöseschwellenwerts ($S_d$) umfasst.

**3.** System zum Detektieren eines Widerstandsfehlers (7) in einem Mittelspannungsnetz (5), das mehrere Mittelspannungs-/Niederspannungs-Transformatorstationen (10, 20, 30) umfasst, die jeweils einen Ausgangspunkt (15, 25, 35) zu mehreren Niederspannungs-Phasenleitern ($15_A$, $15_B$, $15c$) definieren, wobei das System Folgendes umfasst:

- wenigstens eine Detektionsvorrichtung (100) nach einem der vorhergehenden Ansprüche, wobei die Mittel (110, 122, 126) der Detektionsvorrichtung (100) dafür ausgelegt sind, Signale zu empfangen, die Spannungen jedes Leiters jedes Niederspannungsausgangspunkts (15, 25, 35) repräsentieren, Signale zu erhalten, die Phasenspannungen für jeden Ausgangspunkt (15, 25, 35) repräsentieren, daraus die symmetrische Komponente der inversen Spannung ($V_i$) zu bestimmen und den Betrag jeder inversen Spannung ($V_i$) mit dem Auslöseschwellenwert ($S_d$) zu vergleichen, und
- Mittel (D) zum Angeben des Auftretens eines Fehlers (7) in dem Mittelspannungsnetz (5), wenn die Vergleichsmittel (126) ein Ergebnis liefern, in dem eine inverse Spannung ($V_i$) den Auslöseschwellenwert ($S_d$) übersteigt.

**4.** System zum Detektieren eines Widerstandsfehlers (7) in einem Mittelspannungsnetz (5), das mehrere Mittelspannungs-/Niederspannungs-Transformatorstationen (10, 20, 30) umfasst, die jeweils einen Ausgangspunkt (15, 25, 35) zu mehreren Niederspannungs-Phasenleitern definieren, wobei das System eine Detektionsvorrichtung (100, 200, 300) nach einem der Ansprüche 1 oder 2, die jedem Ausgangspunkt (15, 25, 35) zugeordnet ist, und Mittel (D) zum Angeben des Auftretens eines Fehlers (7) in dem Mittelspannungsnetz (5), wenn die Vergleichsmittel (126) einer der Detektionsvorrichtungen (300) ein Ergebnis liefern, in dem der Betrag der inversen Spannung ($V_i$) den Auslöseschwellenwert ($S_d$) überschreitet, umfasst.

**5.** Detektionssystem nach Anspruch 4, wobei sich jede Detektionsvorrichtung (100, 200, 300) in der Transformatorstation (10, 20, 30) befindet.

**6.** Detektionssystem nach einem der Ansprüche 3 bis 5, wobei der Neutralleiter der Mittelspannungs-/Niederspannungs-Transformatorstationen (10, 20, 30) mit Erde verbunden ist, wobei das System außerdem bei jedem Phasenleiter und bei dem Neutralleiter Spannungssensoren aufweist.

**7.** Vorrichtung (100) zum gerichteten Detektieren eines Widerstandsfehlers (7) in einem Mittelspannungsnetz (5), das wenigstens eine Mittelspannungs-/Niederspannungs-Transformatorstation (10) umfasst, die einen Ausgangspunkt (15) zu mehreren Niederspannungs-Phasenleitern ($15_A$, $15_B$, $15_C$) definiert, wobei die Vorrichtung eine Detektionsvorrichtung nach einem der Ansprüche 1 bis 2, Mittel (130) zum Verarbeiten von Signalen, die Phasenspannungen ($V_{AN}$, $V_{BN}$, $V_{CN}$) repräsentieren, und Mittel (140) zum Interpretieren der Ergebnisse der Verarbeitung der Signale, um zu bestimmen, ob der Fehler stromaufseitig oder stromabseitig des Messpunkts der von der Vorrichtung (100) empfangenen Signale vorliegt, umfasst.

8. Vorrichtung zum gerichteten Detektieren nach Anspruch 7, wobei die Verarbeitungsmittel (130) Folgendes umfassen:

  - Mittel (132) zum Berechnen der Norm der Phasenspannungen ($\|V_{AN}\|$, $\|V_{BN}\|$, $\|V_{CN}\|$);
  - Mittel (136) zum Berechnen des Mittelwerts ($\mu$) der Normen ($\|V_{AN}\|$, $\|V_{BN}\|$, $\|V_{CN}\|$);
  - Mittel zum Bestimmen des Minimums ($V_{min}$) der Normen;
  - erste Mittel (138) zum Vergleichen der Norm der Phasenspannungen mit ihrem Mittelwert ($\mu$);
  - zweite Mittel (134) zum Vergleichen des Minimums der Normen mit einem Schwellenwert ($S_v$).

9. System zum Detektieren und Lokalisieren eines Widerstandsfehlers (7) in einem Mittelspannungsnetz (5), das mehrere Mittelspannungs-/Niederspanunungs-Transformatorstationen (10, 20, 30) umfasst, die jeweils einen Ausgangspunkt (15, 25, 35) zu mehreren Niederspannungs-Phasenleitern definieren, wobei das System ein Detektionssystem nach einem der Ansprüche 3 bis 6 umfasst, in dem die Detektionsvorrichtungen (100, 200, 300) Vorrichtungen zum gerichteten Detektieren nach einem der Ansprüche 7 oder 8 sind und in dem die Mittel (D) zum Angeben des Auftretens eines Fehlers (7) in dem Mittelspannungsnetz (5) dafür ausgelegt sind, anzugeben, ob sich der Fehler stromaufseitig oder stromabseitig des Messpunkts der von den Detektionsvorrichtungen empfangenen Signale befindet.

10. Verfahren zum Detektieren eines Erdschlusswiderstandsfehlers (7) in einem Mittelspannungsnetz (5), das Folgendes umfasst: Erhalten der Spannungen jeder Phase von Niederspannungsausgangspunkten (15, 25, 35), die durch das Mittelspannungsnetz (5) versorgt werden, Bestimmen der inversen Spannung ($V_i$) der Niederspannungs-Ausgangspunkte, Vergleichen der Beträge der inversen Spannungen ($V_i$) mit einem Schwellenwert ($S_d$) und Angeben des Auftretens eines Fehlers (7), wenn ein Vergleich wenigstens angibt, dass der Schwellenwert ($S_d$) überschritten wird.

11. Detektionsverfahren nach Anspruch 10, das außerdem das Regulieren der Schwellenwerte ($S_d$) umfasst.

12. Verfahren zum Detektieren und Lokalisieren eines Erdschlusswiderstandsfehlers (7) in einem Mittelspannungsnetz (5), das das Detektionsverfahren nach einem der Ansprüche 10 oder 11 umfasst und außerdem umfasst: Bestimmen der Norm ($\|V_{AN}\|$, $\|V_{BN}\|$, $\|V_{CN}\|$) der Phasenspannungen, Verarbeiten der Normen ($\|V_{AN}\|$, $\|V_{SN}\|$, $\|V_{CN}\|$) der Phasenspannungen und Bestimmen, ob sich der detektierte Fehler stromaufseitig oder stromabseitig des Messpunkts befindet.

13. Verfahren zum Detektieren und Lokalisieren nach Anspruch 12, wobei die Verarbeitung der Normen das Berechnen ihres arithmetischen Mittelwerts, das Vergleichen der Amplitude der Spannungen mit ihrem Mittelwert und das Vergleichen des Spannungsminimums mit einem Schwellenwert umfasst.

**Claims**

1. A device (100) for detecting a resistive earth fault (7) in a medium-voltage power grid (5) which comprises at least one medium-voltage / low-voltage transformer substation (10) defining a feeder (15) providing a plurality of low-voltage phase conductors ($15_A$, $15_B$, $15_C$), said device (100) comprising:

  means for receiving signals representative of the voltages of each conductor of a low-voltage feeder (15);
  means for obtaining (110) signals representative of the phase voltages ($V_{AN}$, $V_{BN}$, $V_{CN}$) from the received voltage signals;
  means (122) for determining the symmetric reverse voltage component ($V_i$) of the feeder;
  means (126) for comparing the reverse voltage ($V_i$) with a tripping threshold ($S_d$).

2. The detection device according to claim 1 further comprising means (128) for adjusting the tripping threshold ($S_d$).

3. A system for detecting a resistive fault (7) in a medium-voltage power grid (5) which comprises a plurality of medium-voltage / low-voltage transformer substations (10, 20, 30) each defining a feeder (15, 25, 35) providing a plurality of low-voltage phase conductors ($15_A$, $15_B$, $15_C$), said system comprising:

at least one detection device (100) according to one of the foregoing claims, the means (110, 122, 126) of said detection device (100) being designed to receive signals representative of the voltages of each conductor of each low-voltage feeder (15, 25, 35), to obtain signals representative of the phase voltages for each feeder (15, 25, 35), to determine the symmetric reverse voltage component ($V_i$) therefrom, and to compare the module of each reverse voltage ($V_i$) with the tripping threshold ($S_d$), and
means for indicating (D) the occurrence of a fault (7) in the medium-voltage power grid (5) when the comparison means (126) give a result in which a reverse voltage ($V_i$) exceeds the tripping threshold ($S_d$).

4. A system for detecting a resistive fault (7) in a medium-voltage power grid (5) which comprises a plurality of medium-voltage / low-voltage transformer substations (10, 20, 30) each defining a feeder (15, 25, 35) providing a plurality of low-voltage phase conductors, said system comprising a detection device (100, 200, 300) according to one of claims 1 or 2 associated with each feeder (15, 25, 35) and means for indicating (D) the occurrence of a fault (7) in the medium-voltage power grid (5) when the comparison means (126) of one of the detection devices (300) give a result in which the module of the reverse voltage ($V_i$) exceeds the tripping threshold ($S_d$).

5. The detection system according to claim 4 wherein each detection device (100, 200, 300) is located in the transformer substation (10, 20, 30).

6. The detection system according to one of claims 3 to 5 wherein the neutral of the medium-voltage / low-voltage transformer substations (10, 20, 30) is earthed, and further comprising voltage sensors on each phase conductor and on the neutral conductor.

7. A device (100) for directional detection of a resistive fault (7) in a medium-voltage power grid (5) which comprises at least one medium-voltage / low-voltage transformer substation (10) defining a feeder (15) providing a plurality of low-voltage phase conductors ($15_A$, $15_B$, $15_C$), said device comprising a detection device according to one of claims 1 to 2, processing means (130) of the signals representative of the phase voltages ($V_{AN}$, $V_{BN}$, $V_{CN}$), and means (140) for interpreting the results of processing of the signals to determine whether the fault is upstream or downstream of the measuring point of the signals received by said device (100).

8. The directional detection device according to claim 7 wherein the processing means (130) comprise:

means (132) for computing the norm of the phase voltages ($\|V_{AN}\|$, $\|V_{BN}\|$, $\|V_{CN}\|$);
means (136) for computing the mean ($\mu$) of the norms ($\|V_{AN}\|$, $\|V_{BN}\|$, $\|V_{CN}\|$);
means for determining the minimum of the norms ($V_{min}$);
first means (138) for performing comparison of the norm of the phase voltages with their mean ($\mu$);
second means (134) for performing comparison of the minimum of the norms with a threshold ($S_v$).

9. A system for detection and location of a resistive fault (7) in a medium-voltage power grid (5) which comprises a plurality of medium-voltage / low-voltage transformer substations (10, 20, 30) each defining a feeder (15, 25, 35) providing a plurality of low-voltage phase conductors, said system comprising a detection system according to one of claims 3 to 6 wherein the detection devices (100, 200, 300) are directional detection devices according to one of claims 7 or 8, and wherein the means for indicating (D) the occurrence of a fault (7) in the medium-voltage power grid (5) are designed to indicate whether the fault is line-side or load-side from the measuring point of the signals received by said detection devices.

10. A detection method of a resistive earth fault (7) on a medium-voltage power grid (5) comprising obtaining the voltages of each phase of the low-voltage feeders (15, 25, 35) supplied by the medium-voltage power grid (5), determination of the reverse voltage ($V_i$) of the low-voltage feeders, comparison of the modules of the reverse voltages ($V_i$) with a threshold ($S_d$), and indication of the occurrence of a fault (7) when at least one comparison indicates that the threshold ($S_d$) has been overshot.

11. The detection method according to claim 10 further comprising adjustment of the thresholds ($S_d$).

12. A method for detection and location of a resistive earth fault (7) on a medium-voltage power grid (5) comprising the detection method according to one of claims 10 or 11, determination of the norm of the phase voltages ($\|V_{AN}\|$, $\|V_{BN}\|$, $\|V_{CN}\|$), processing of the norms of the phase voltages ($\|V_{AN}\|$, $\|V_{BN}\|$, $\|V_{CN}\|$), and determination of the location of the detected fault line-side or load-side from the measuring point.

13. The detection and location method according to claim 12 wherein processing of the norms comprises computation of their arithmetic mean, comparison of the amplitude of the voltages with their mean, and comparison of the voltage minimum with a threshold.

**Fig. 1**

i)

ii)

iii)

iv)

$V_l < S_d$

$[V > \mu] = 1$

$V_l > S_d$

$V_{AN}, V_{BN}, V_{CN}, V_i$

**Fig. 2A**

Fig. 2B

$[V>\mu] = 2$

$Min(V)>S_v$

$V_i > S_d$

$Min(V)<S_v$

$V_i < S_d$

$V_{AN}, V_{BN}, V_{CN}, V_i$

**Fig. 2C**

Début

110 → $V_A$, $V_B$, $V_C$, $V_N$

122 → $V_i$

126 → $V_i > S_d$ ?  N

O

D

132 → $\|V_{AN}\|$, $\|V_{BN}\|$, $\|V_{CN}\|$

136 → $\mu = \Sigma \|V_{XN}\| /3$

138 → $[\|V_{AN}\| > \mu + \|V_{BN}\| > \mu + \|V_{CN}\| > \mu] \geq 2$ ?  N

$V_{min} = $ min $(\|V_{AN}\|, \|V_{BN}\|, \|V_{CN}\|)$

$V_{min} > S_V$ ?  N

L

Défaut en AVAL

L

Défaut en AMONT

**Fig.3**

Fig.4

EP 2 533 060 B1

**EP 2 533 060 B1**

**RÉFÉRENCES CITÉES DANS LA DESCRIPTION**

**Documents brevets cités dans la description**

- EP 1603211 A